# EUROPEAN PATENT APPLICATION

(11) **EP 1 536 485 A1**
(43) Date of publication of application: **01.06.2005**
(21) Application number: 04090468.2
(22) Date of filing: 26.11.2004
(51) Int. Cl.: H01L 29/92, G02F 1/1362

(54) **Capacitor and flat panel display having the same**

(30) Priority: 27.11.2003 KR 2003084880
(71) Applicant: Samsung SDI Co., Ltd., Suwon-si, Gyeonggi-do (KR)
(72) Inventor: Kim, Deuk-Jong, Seoul (KR); Hwang, Eui-Hoon, Dongan-gu Anyang-si Gyeonggi-do (KR)
(74) Representative: Hengelhaupt, Jürgen, Dipl.-Ing.

(57) **Abstract**

A capacitor that may prevent current leakage, destruction of an insulating layer, and a short circuit at an edge portion of an electrode, and a flat panel display including the same, are provided. The capacitor includes at least two electrodes, disposed in a stacked structure, that are insulated from each other, wherein each electrode is smaller than a lower electrode.

## Description

This application claims the benefit of Korean Patent Application No. 2003-84880, filed on November 27, 2003, which is hereby incorporated by reference for all purposes as if fully set forth herein.

### BACKGROUND OF THE INVENTION

### Field of the Invention

The present invention relates to a capacitor and a flat panel display having the capacitor, and more particularly, to a capacitor with an improved electrode structure and a flat panel display including the same.

### Discussion of the Related Art

Passive elements, such as resistors and capacitors, and active elements, such as thin film transistors (TFTs), diodes, and metal oxide semiconductor field effect transistors (MOSFETs), are used in integrated circuits and flat panel displays.

Large capacity capacitors may be required to manufacture an integrated circuit with high integration density that operates at high speed. In the case of flat panel displays, such as liquid crystal displays, organic light emitting displays, and inorganic light emitting displays, a plurality of storage capacitors may be formed to correspond to one pixel, thereby improving the display's picture quality. Storage capacitors store data signals during a predetermined time frame.

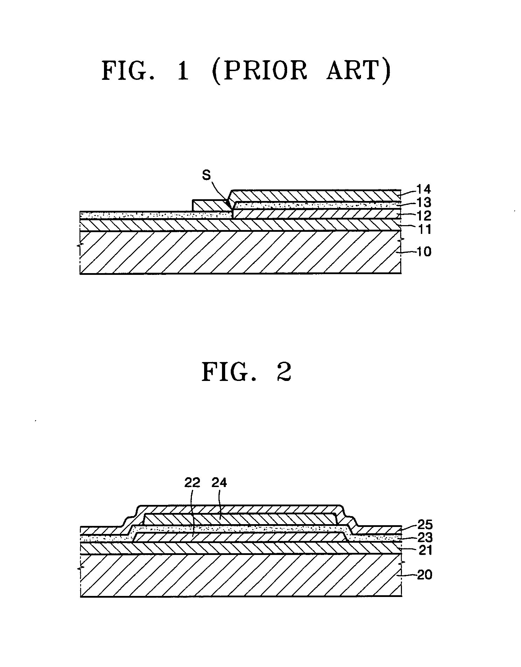

FIG. 1 illustrates a conventional capacitor that generally may be used in a semiconductor device or a flat panel display. The capacitor includes a sequentially formed substrate 10, a buffer layer 11, a lower electrode 12, an insulating layer 13 covering the lower electrode 12, and an upper electrode 14 overlapping the lower electrode 12.

In a capacitor with the above structure, the upper electrode 14 is formed wider than the lower electrode 12 due to a process margin for patterning and a wiring structure plan. Specifically, when a mask align operation is performed using an exposure unit to pattern the upper electrode 14, a process margin is formed on the upper electrode 14 to compensate for an exposure unit align error. Also, by considering the process margin, the plan of a through hole for connecting a data line and the wiring structure of the upper electrode 14 is easily laid out.

However, referring to FIG. 1, when the upper electrode 14 is formed wider than the lower electrode 12, the insulating layer 13 relatively thin at an edge portion S of the lower electrode 12, which may permit current leakage. Current leakage may destroy insulation between the upper and lower electrodes 14 and 12, which may permit a short circuit between them.

A TFT used in a flat panel display generally employs polysilicon active layers to achieve a high response speed and dynamic display images. With a front emitting type display, increasing the number of TFTs per pixel may improve the aperture ratio. In this case, a polysilicon active layer may be used as the capacitor's lower electrode 12.

However, when polysilicon is used as the lower electrode 12, current leakage may increase because polysilicon is typically rougher than a metal used to manufacture the lower electrode 12. Therefore, deterioration of the insulating layer 13 at the relatively thin edge portion S may become very problematic.

### SUMMARY OF THE INVENTION

The present invention provides a capacitor that may be capable of preventing current leakage, insulation destruction, and short circuits generated at the step of a lower electrode.

The present invention also provides a flat panel display including the capacitor.

Additional features of the invention will be set forth in the description which follows, and in part will be apparent from the description, or may be learned by practice of the invention.

The present invention discloses a capacitor, comprising at least two electrodes, disposed in a stacked structure, that are insulated from each other, wherein each electrode is smaller than a lower electrode.

The present invention also discloses a capacitor, comprising at least two electrodes, disposed in a stacked structure, that are insulated from each other, wherein each electrode does not overlap an edge portion of a lower electrode.

The present invention also discloses a flat panel display, comprising a light emitting device, a thin film transistor and a capacitor. Each thin film transistor has a semiconductor thin film, a gate electrode insulated from the semiconductor thin film, and source and drain electrodes coupled to the semiconductor thin film. The capacitor has at least two electrodes, disposed in a stacked structure, that are insulated from each other. Each electrode of the capacitor is smaller than a lower electrode of the capacitor.

The present invention also discloses a flat panel display, comprising a light emitting device, a thin film transistor and a capacitor. The thin film transistor has a semiconductor thin film, a gate electrode that is insulated from the semiconductor thin film, a source electrode and a drain electrode coupled to the semiconductor thin film. The capacitor has at least two electrodes, disposed in a stacked structure, that are insulated from each other. Each electrode of the capacitor does not overlap an edge portion of a lower electrode of the capacitor.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

FIG. 1 is a cross-sectional view of a conventional capacitor showing an edge portion of a lower electrode.

FIG. 2 is a cross-sectional view illustrating a capacitor according to a first exemplary embodiment of the present invention.

FIG. 3 is a cross-sectional view illustrating a double capacitor according to a second exemplary embodiment of the present invention.

FIG. 4 is a cross-sectional view illustrating a sub-pixel of an active matrix type organic electroluminescent display according to a third exemplary embodiment of the present invention.

FIG. 5 is a cross-sectional view illustrating the sub-pixel of an active matrix type organic electroluminescent display according to a fourth exemplary embodiment of the present invention.

FIG. 6 is a cross-sectional view illustrating the sub-pixel of an active matrix type organic electroluminescent display according to a fifth exemplary embodiment of the present invention.

### DETAILED DESCRIPTION OF THE INVENTION

FIG. 2 illustrates a capacitor according to a first exemplary embodiment of the present invention. The capacitor comprises a first electrode and second electrode. In exemplary embodiments of the present invention, "on" does not require physical contact. In other words, one layer formed on another may physically touch that layer or there may be additional layers between them.

A buffer layer 21 is formed on a substrate 20, a first electrode 22 is formed on the buffer layer 21, a first insulating layer 23 is formed to cover the first electrode 22, a second electrode 24 is formed on the first insulating layer 23, and a second insulating layer 25 is formed to cover the second electrode 24.

With a flat panel display, the substrate 20 may be formed of glass or plastic. The buffer layer 21 and the substrate 20 may form a single body.

On the other hand, with a semiconductor device, the substrate 20 may be formed of a P type silicon or an N type silicon. In this case, the buffer layer 21 may be omitted.

The first electrode 22 and second electrode 24 may be formed of a conductive material such as metal, a semiconductor thin film, such as conductive polysilicon, a conductive polymer, or other like substances. The material of the first electrode 22 and second electrode 24 may be any material that can be used for a capacitor electrode in a semiconductor device or a flat panel display.

The first insulating layer 23, interposed between the first electrode 22 and the second electrode 24, may be used as a dielectric layer, and it may be formed of SiO₂, SiNₓ, or other like materials.

The first electrode 22 may be formed to be larger than the second electrode 24. Also, the second electrode 24 may not overlap an edge portion of the first electrode 22. The second electrode 24 wiring may be disposed above an edge portion of the first electrode 22, and an electrode body of the second electrode 24 may be located at an area corresponding to the pattern of the first electrode 22.

Forming the first electrode 22 and second electrode 24 as described above may prevent insulation destruction of the insulating layer 23. It also may prevent a current leakage at the edge portion of the first electrode 22 and a short circuit between the first electrode 22 and second electrode 24.

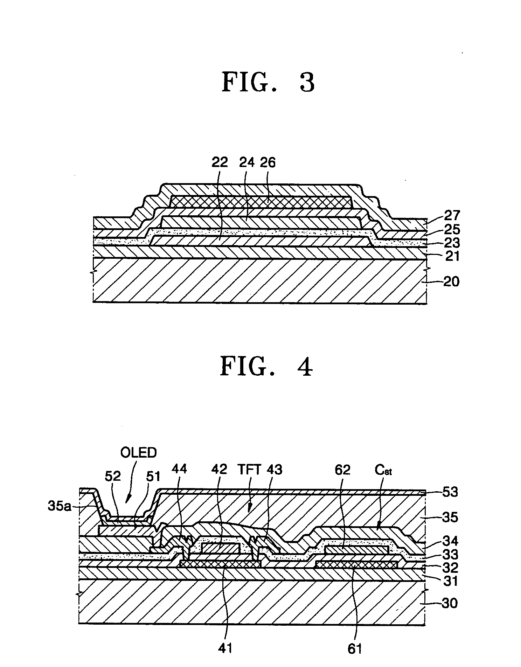

FIG. 3 illustrates a double capacitor according to a second exemplary embodiment of the present invention.

The second exemplary embodiment differs from the first exemplary embodiment in that a third electrode 26 is formed on the second insulating layer 25, and a third insulating layer 27 is formed on the third electrode 26. A first electrode 22, a first insulating layer 23, and a second electrode 24 form a first capacitor. The second electrode 24, a second insulating layer 25, and a third electrode 26 form a second capacitor.

In the second exemplary embodiment, the second electrode 24 is greater than the third electrode 26. The third electrode 26 may be patterned within the pattern of the second electrode 24. Therefore, a current leakage, insulation destruction of the insulating layer 25, and a short circuit may be easily prevented.

The capacitor as described above may be used in various semiconductor devices and flat panel displays, including liquid crystal displays, organic electroluminescent displays, and inorganic electroluminescent displays.

FIG. 4 is a cross-sectional view illustrating a sub-pixel of an active type organic electroluminescent display according to a third exemplary embodiment of the present invention. The capacitor according to exemplary embodiments of the present invention may be applied not only as a storage capacitor in a sub-pixel, but it may also be used for different types of drivers.

The organic electro luminescent display comprises a self-luminescent organic light emitting diode (OLED), at least one thin film transistor (TFT) connected to the OLED, and a storage capacitor Cst, as shown in FIG. 4.

Referring to FIG. 4, a buffer layer 31 may be formed on an insulating substrate 30, which may be formed of glass, and the thin film transistor TFT and the capacitor Cst are formed above the buffer layer 31. The buffer layer 31 may be formed of SiO₂, and deposited to a thickness of about 3000Å using as a method such as plasma enhanced chemical vapor deposition (PECVD), atmospheric pressure chemical vapor deposition (APCVD), low pressure chemical vapor deposition (LPCVD), electron cyclotron resonance (ECR), or other like methods. The insulating substrate 30 may be formed of plastic, and in this case, the buffer layer 31 may be omitted.

The thin film transistor TFT includes an active layer 41 formed on the buffer layer 31, a gate insulating layer 32 formed above the active layer 41, a gate electrode 42 formed above the gate insulating layer 32, and a source electrode 43 and a drain electrode 44 connected to the active layer 41.

The active layer 41 may be formed of inorganic semiconductor or organic semiconductor material at a thickness of about 500Å. When the active layer 41 is formed of a polysilicon inorganic semiconductor, amorphous silicon may be formed and crystallized by various types of crystallization methods. The active layer 41 includes a source region and a drain region doped with high-density N-type or P-type impurities, and a channel region between the source region and the drain region.

The inorganic semiconductor may include CdS, GaS, ZnS, CdSe, CaSe, ZnSe, CdTe, SiC, silicon, including amorphous silicon or polysilicon, or other like materials.

The organic semiconductor may include a semiconductive organic material having a band gap of 1ev through 4ev. The semiconductive organic material may include a polymer and a monomer. Examples of the monomer include polythiophene and its derivative, polyparaphenylenevenylene and its derivative, polyparaphenylene and its derivative, polyfluorene and its derivative, polythiophenevinylene and its derivative, polythiophene-Heterocyclic Aromatic Co and its derivative, and other like substances. Examples of the polymer include pentacene, tetracene, oligoacene of naphthalene, and their derivatives, alpha-6-thiophene, oligothiophene of alpha-5-thiophene, and their derivatives, phthalocyanines with or without metal, and their derivatives, pyromellitic dianhydride or pyromellitic diimide, and their derivatives, perylenetetracarbocxylic acid dianhydride or perylenetetracarboxylic acid diimide and their derivatives, and other like substances.

The gate insulating layer 32 may be formed of SiO₂, and a gate electrode 42 may be formed as a conductive metal layer of MoW, Al, Cr, or Al/Cu. Other conductive materials, including a conductive polymer, may be used for the gate electrode 42. The gate electrode 42 is coupled to a gate line applying TFT on/off signals, and a region of the gate electrode 42 corresponds to a channel region of the active layer 41.

An inter-insulating layer 33, above the gate electrode 42, may be formed of SiO₂, SiNₓ or other like substances. The source electrode 43 and the drain electrode 44 are formed above the inter-insulating layer 33, and contact holes are punched in the inter-insulating layer 33 and gate insulating layer 32. The source and drain electrodes 43 and 44 may be formed of a conductive metal layer such as MoW, Al, Cr, or Al/Cu, and a conductive polymer.

A passivation layer 34, which may be formed of SiNₓ, is formed above the source and drain electrodes 43 and 44, and a pixel-definition layer 35, which may be formed of acryl or polyimid, is formed above the passivation layer 34.

The thin film transistor TFT is not restricted to the above structure. It may have various structures of a conventional thin film transistor.

The drain electrode 44 is coupled to an anode electrode 51 of the organic light emitting diode OLED. The anode electrode 51 is formed above the passivation layer 34, and the pixel-definition layer 35 is formed above the anode electrode 51. An opening 35a may be formed in the pixel-definition layer 35, and the organic light emitting diode OLED is formed therein.

The organic light emitting diode OLED displays images by emitting red, green, and blue light in accordance with the flow of current. The organic light emitting diode OLED is comprised of the anode electrode 51, a cathode electrode 53, and an organic light emitting layer 52 interposed between them The anode electrode 51 may be coupled to the drain electrode 44, and the cathode electrode 53 may be formed to cover all pixels of the active matrix type organic electroluminescent display.

The anode electrode 51 may be formed of a transparent electrode like ITO, or of a reflex type electrode such as Al/ITO. With a rear emitting display, the cathode electrode 53 may be formed of Al/Ca, and with a front emitting display, it may be formed of a transparent electrode such as Mg-Ag/ITO. The positions of the anode electrode 51 and the cathode electrode 53 may be interchanged.

The organic light emitting layer 52 may be formed of a low molecular organic layer or a high molecular organic layer.

When the low molecular organic layer is used, a Hole Injection Layer (HIL), a Hole Transport Layer (HTL), an Emission Layer (EML), an Electron Transport Layer (ETL), and an Electron Injection Layer (EIL) may be deposited and formed in a single layer structure or in a multiple layer structure. Copper phthalocyanine CuPc, N, N'-Di(naphthalene-1-yl)-N, N'-diphenyl-benzidine NPB, tris-8-hydroxyquinoline aluminum Alq3, or other like substances may be used as the low polymer layer. The low polymer layers as described above may be formed by vacuum deposition.

The high molecular layer may have a structure including an HTL and an EML. In this case, the HTL may be formed of PEDOT, and the EML may be formed of poly-phenylenevinylene PPV and polyfluorene. Screen printing or ink jet printing may be used to form these layers.

The structure of the organic light emitting diode is not restricted to the above.

The capacitor Cst includes a first electrode 61 formed above the buffer layer 31, and a second electrode 62 formed above the first electrode 61. The gate insulating layer 32 is interposed between the first electrode 61 and second electrode 62.

In accordance with an exemplary embodiment of the present invention, the first electrode 61 may be formed of the same material as the active layer 41, and the second electrode 62 may be formed of the same material as the gate electrode 42. The first electrode 61 and second electrode 62 may be formed simultaneously with the active layer 41 and gate electrode 42, respectively. The first electrode 61 may be connected to a driving power line Vdd, and the second electrode 62 may be connected to the source electrode of TFT, but this configuration is not restricted to the above description.

In this case, the second electrode 62 may be formed smaller than the first electrode 61, and an edge portion of the first electrode 61 may not overlap with the second electrode 62. The second electrode 62 may be located within the pattern of the first electrode 61.

Since the edge portion of the first electrode 61 does not overlap the second electrode 62, the insulation destruction of the gate insulating layer 32, current leakage and a short-circuit occurring at the edge portion of the first electrode 61 may be prevented.

Referring to FIG. 4, when the active layer 41 and the first electrode 61 are formed of polysilicon, a surface with a higher roughness and a larger step may be formed. Therefore, the method described above is useful to solve the problems of current leakage, destruction of the insulating layer, and short-circuiting of capacitor electrodes.

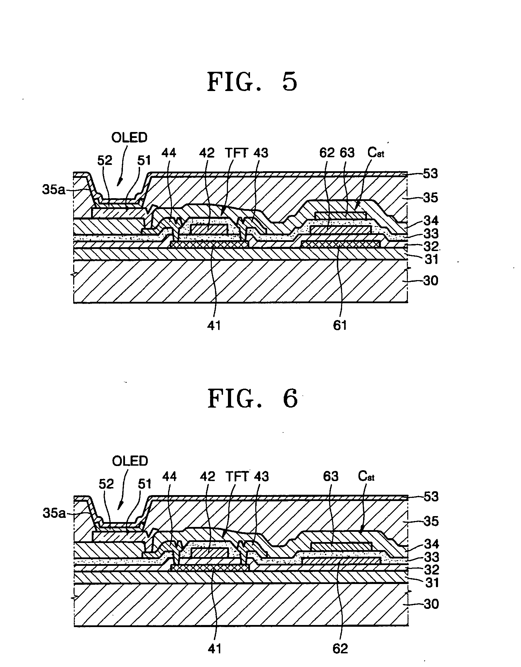

The structure of the capacitor of the fourth exemplary embodiment of the present invention, as shown in FIG. 5, may be applied to a double capacitor in which a third electrode 63 is formed of the same material as the source and drain electrodes 43 and 44 of the thin film transistor TFT. The third electrode 63 is smaller than the second electrode 62 in that the pattern of the third electrode 63 corresponds to an area within the pattern of the second electrode 62, so that an edge portion of the third electrode 63 does not overlap the second electrode 62.

The structure of the capacitor, of the fifth exemplary embodiment of the present invention, as shown in FIG. 6, may be applied to a capacitor formed with only the second electrode 62 and the third electrode 63. Unlike the fourth embodiment, the fifth embodiment does not have a first electrode 61. Referring to FIG. 6, similar to the fourth embodiment, the third electrode 63 is smaller than the second electrode 62in that the pattern of the third electrode 63 corresponds to an area within the pattern of the second electrode 62, so that edge portion of the second electrode 62 is not under the third electrode 63. As such, problems of current leakage, destruction of the insulating layer, and short-circuit may be solved.

Exemplary embodiments of the present invention may be also applied to liquid crystal displays and inorganic electroluminescent displays.

As described above, according to exemplary embodiments of the present invention, the following effects are obtained.

First, current leakage caused by a thin insulating layer in a portion corresponding to a step of a lower electrode may be solved.

Second, the insulation destruction of a thin insulating layer near the step of the lower electrode may be prevented.

Third, a short-circuit between an upper electrode and a lower electrode caused by the insulation destruction of the insulating layer or racking of the insulating layer, may be prevented.

It will be apparent to those skilled in the art that various modifications and variation can be made in the present invention without departing from the spirit or scope of the invention. Thus, it is intended that the present invention cover the modifications and variations of this invention provided they come within the scope of the appended claims and their equivalents.

## Claims

1. A capacitor, comprising:
at least two electrodes, disposed in a stacked structure, that are insulated from each other,
wherein each electrode is smaller than a lower electrode.

2. The capacitor of claim 1, wherein at least one electrode is a semiconductor thin film.

3. The capacitor of claim 2, wherein the semiconductor thin film is formed of polysilicon.

4. The capacitor of claim 1, wherein at least one electrode is formed of a metal.

5. The capacitor of claim 1, wherein at least one electrode is formed of a conductive polymer.

6. A capacitor, comprising:
at least two electrodes, disposed in a stacked structure, that are insulated from each other,
wherein each electrode does not overlap an edge portion of a lower electrode.

7. The capacitor of claim 6, wherein at least one electrode is a semiconductor thin film.

8. The capacitor of claim 7, wherein the semiconductor thin film is formed of polysilicon.

9. The capacitor of claim 6, wherein at least one electrode is formed of a metal.

10. The capacitor of claim 6, wherein at least one electrode is formed of a conductive polymer.

11. A flat panel display, comprising:
a light emitting device;
a thin film transistor, coupled to the light emitting device, further comprising:
a semiconductor thin film;
a gate electrode insulated from the semiconductor thin film;
a source electrode coupled to the semiconductor thin film; and
a drain electrode coupled to the semiconductor thin film; and
a capacitor having at least two electrodes, disposed in a stacked structure and insulated from each other;
wherein each electrode of the capacitor is smaller than a lower electrode of the capacitor.

12. The flat panel display of claim 11, wherein a capacitor electrode is formed of a same material as the semiconductor thin film.

13. The flat panel display of claim 12, wherein the capacitor electrode and the semiconductor thin film are formed of polysilicon.

14. The flat panel display of claim 11, wherein a capacitor electrode is formed of a same material as the gate electrode.

15. The flat panel display of claim 11, wherein a capacitor electrode is formed of a same material as the source electrode and the drain electrode.

16. A flat panel display, comprising:
a light emitting device;
a thin film transistor, coupled to the light emitting device, further comprising:
a semiconductor thin film;
a gate electrode that is insulated from the semiconductor thin film;
a source electrode coupled to the semiconductor thin film; and
a drain electrode coupled to the semiconductor thin film; and
a capacitor having at least two electrodes, disposed in a stacked structure and insulated from each other,
wherein each electrode of the capacitor does not overlap an edge portion of a lower electrode of the capacitor.

17. The flat panel display of claim 16, wherein a capacitor electrode is formed of a same material as the semiconductor thin film.

18. The flat panel display of claim 17, wherein the capacitor electrode and the semiconductor thin film are formed of polysilicon.

19. The flat panel display of claim 16, wherein a capacitor electrode is formed of a same material as the gate electrode.

20. The flat panel display of claim 16, wherein a capacitor electrode is formed of a same material as the source electrode and the drain electrode.
